# EUROPEAN PATENT APPLICATION

(11) **EP 4 746 618 A1**
(43) Date of publication of application: **20.05.2026**
(21) Application number: 25214596.6
(22) Date of filing: 10.11.2025
(51) Int. Cl.: H10B 12/00, G11C 7/18, G11C 11/4097

(54) **STACKED MEMORY WITH FOLDED BITLINE AND STAGGERED CHANNEL**

(30) Priority: 13.11.2024 US 202463720157 P; 08.08.2025 US 202519295542
(71) Applicant: Samsung Electronics Co., Ltd., Suwon-si, Gyeonggi-do 16677 (KR)
(72) Inventor: LEE, Don Koun, San Jose, CA, 95134 (US); KIM, Dongwan, San Jose, CA, 95134 (US)
(74) Representative: Kuhnen & Wacker Patent- und Rechtsanwaltsbüro PartG mbB

(57) **Abstract**

Provided are systems, methods, and apparatuses for stacked memory based on a folded bitline and staggered semiconductor channels. The systems, devices, and methods include offsetting a position of a first set of isolation trenches (120) relative to a position of a second set of isolation trenches (125); forming a first local bitline (140) at a first angle relative to an orientation of the first set of isolation trenches (120) and the second set of isolation trenches (125); offsetting a position of a third set of isolation trenches (130) relative to a position of a fourth set of isolation trenches (135); and forming a second local bitline (145) at a second angle relative to an orientation of the third set of isolation trenches (130) and the fourth set of isolation trenches (135), the second angle being different from the first angle.

## Description

### TECHNICAL FIELD

The disclosure relates generally to memory systems. In particular, the subject matter relates to stacked memory based on a folded bitline and staggered semiconductor channels.

### BACKGROUND

The present background section is intended to provide context only, and the disclosure of any concept in this section does not constitute an admission that said concept is prior art.

Memory chips can include integrated circuits that store and retrieve data in digital devices, such as computers, mobile devices, etc. Memory chips can store data temporarily or permanently. Memory chips can include random-access memory (RAM), dynamic random-access memory (DRAM), read-only memory (ROM), flash memory, etc. Memory chips can include output lines that connect to a system data bus. Some memory chips may be cut from a wafer and placed in individual housings. Memory chips can be mounted to a printed circuit board (PCB), incorporated on a system on chip (SoC), stacked vertically, etc.

### SUMMARY

In various embodiments, the systems and methods described herein include systems, methods, and apparatuses for stacked memory based on a folded bitline and staggered semiconductor channels. In some aspects, the techniques described herein relate to a stacked memory device including: a first set of isolation trenches and a second set of isolation trenches, a position of the first set of isolation trenches being offset relative to a position of the second set of isolation trenches; a first local bitline formed at a first angle relative to an orientation of the first set of isolation trenches and the second set of isolation trenches; a third set of isolation trenches and a fourth set of isolation trenches, a position of the third set of isolation trenches being offset relative to a position of the fourth set of isolation trenches; and a second local bitline formed at a second angle relative to an orientation of the third set of isolation trenches and the fourth set of isolation trenches, the second angle being different from the first angle.

In some aspects, the techniques described herein relate to a stacked memory device, wherein the first angle of the first local bitline ranges from 10 degrees to 80 degrees relative to the orientation of the first set of isolation trenches and the second set of isolation trenches that are oriented at a zero angle.

In some aspects, the techniques described herein relate to a stacked memory device, wherein: a first connector connects the first local bitline to a first global bitline, the first global bitline connects the first local bitline to a first sense amplifier, and the first global bitline is positioned at the zero angle.

In some aspects, the techniques described herein relate to a stacked memory device, wherein: the second angle of the second local bitline ranges from 100 degrees to 170 degrees relative to the orientation of the third set of isolation trenches and the fourth set of isolation trenches that are oriented at a zero angle.

In some aspects, the techniques described herein relate to a stacked memory device, wherein: a second connector connects the second local bitline to a second global bitline, the second global bitline connects the second local bitline to a second sense amplifier, and the second global bitline is positioned at the zero angle.

In some aspects, the techniques described herein relate to a stacked memory device, wherein a first portion of the first local bitline is formed between a first isolation trench and a second isolation trench of the first set of isolation trenches.

In some aspects, the techniques described herein relate to a stacked memory device, wherein a second portion of the first local bitline is formed between a third isolation trench of and a fourth isolation trench of the second set of isolation trenches.

In some aspects, the techniques described herein relate to a stacked memory device, wherein the first local bitline connects to a first column of memory cells and a second column of memory cells.

In some aspects, the techniques described herein relate to a stacked memory device including: a first set of isolation trenches and a second set of isolation trenches, a position of the first set of isolation trenches being offset relative to a position of the second set of isolation trenches; a first local bitline formed between a first isolation trench and a second isolation trench of the first set of isolation trenches; and a second local bitline formed between a third isolation trench of and a fourth isolation trench of the second set of isolation trenches.

In some aspects, the techniques described herein relate to a stacked memory device, wherein a position of the first local bitline is offset relative to a position of the second local bitline.

In some aspects, the techniques described herein relate to a stacked memory device, wherein an angle between the first local bitline and the second local bitline ranges from 10 degrees to 80 degrees relative to an orientation of the first set of isolation trenches and the second set of isolation trenches that are oriented at a zero angle.

In some aspects, the techniques described herein relate to a stacked memory device, wherein: a first connector connects the first local bitline to a first global bitline, and the first global bitline connects the first local bitline to a first sense amplifier.

In some aspects, the techniques described herein relate to a stacked memory device, wherein: the first global bitline is positioned at least partially between the first isolation trench and the second isolation trench, and the first global bitline is positioned at a zero angle.

In some aspects, the techniques described herein relate to a stacked memory device, wherein: a second connector connects the second local bitline to a second global bitline, and the second global bitline connects the second local bitline to a second sense amplifier.

In some aspects, the techniques described herein relate to a stacked memory device, wherein: the second global bitline is positioned at least partially between the third isolation trench and the fourth isolation trench, and the second global bitline is positioned at a zero angle.

In some aspects, the techniques described herein relate to a stacked memory device, wherein: the first local bitline connects to a first column of memory cells, and the second local bitline connects to a second column of memory cells.

In some aspects, the techniques described herein relate to a method including: offsetting a position of a first set of isolation trenches relative to a position of a second set of isolation trenches; forming a first local bitline at a first angle relative to an orientation of the first set of isolation trenches and the second set of isolation trenches; offsetting a position of a third set of isolation trenches relative to a position of a fourth set of isolation trenches; and forming a second local bitline at a second angle relative to an orientation of the third set of isolation trenches and the fourth set of isolation trenches, the second angle being different from the first angle.

In some aspects, the techniques described herein relate to a method, wherein the first angle of the first local bitline ranges from 10 degrees to 80 degrees relative to the orientation of the first set of isolation trenches and the second set of isolation trenches that are oriented at a zero angle.

In some aspects, the techniques described herein relate to a method, wherein: a first connector connects the first local bitline to a first global bitline, the first global bitline connects the first local bitline to a first sense amplifier, and the first global bitline is positioned at a zero angle.

In some aspects, the techniques described herein relate to a method, wherein: the second angle of the second local bitline ranges from 100 degrees to 170 degrees relative to the orientation of the third set of isolation trenches and the fourth set of isolation trenches that are oriented at a zero angle.

A computer-readable medium is disclosed. The computer-readable medium can store instructions that, when executed by a computer, cause the computer to perform substantially the same or similar operations as described herein are further disclosed. Similarly, non-transitory computer-readable media, devices, and systems for performing substantially the same or similar operations as described herein are further disclosed.

The systems and methods described herein include multiple advantages and benefits. For example, memory devices based on the systems and methods described herein may include a sense amplifier (SA) with increased pitch margin that is enabled based on the folded bitline architecture. For example, the systems and methods described herein may provide increased leeway in the physical layout of the sense amplifier within the constraints of a memory cell array based on the pitch or spacing of the bitlines, where the pitch of the bitlines is due to the folded bitline architecture. Also, memory devices may be configured for bonding integration with core and peripheral transistors based on the folded bitline systems and methods described herein.

### BRIEF DESCRIPTION OF THE DRAWINGS

The above-mentioned aspects and other aspects of the present systems and methods will be better understood when the present application is read in view of the following figures, in which like numbers indicate similar or identical elements. Further, the drawings provided herein are for purpose of illustrating certain embodiments only; other embodiments, which may not be explicitly illustrated, are not excluded from the scope of this disclosure.

These and other features and advantages of the present disclosure will be appreciated and understood with reference to the specification, claims, and appended drawings, wherein:
FIG. 1 illustrates an example architecture in accordance with one or more implementations as described herein.
FIG. 2 illustrates an example architecture in accordance with one or more implementations as described herein.
FIG. 3 illustrates an example architecture in accordance with one or more implementations as described herein.
FIG. 4 illustrates an example architecture in accordance with one or more implementations as described herein.
FIG. 5 depicts a flow diagram illustrating an example method associated with the disclosed systems, in accordance with example implementations described herein.
FIG. 6 depicts a flow diagram illustrating an example method associated with the disclosed systems, in accordance with example implementations described herein.

While the present systems and methods are susceptible to various modifications and alternative forms, specific embodiments thereof are shown by way of example in the drawings and will herein be described. The drawings may not be to scale. It should be understood, however, that the drawings and detailed description thereto are not intended to limit the present systems and methods to the particular form disclosed, but to the contrary, the intention is to cover all modifications, equivalents, and alternatives falling within the scope of the present systems and methods as defined by the appended claims.

### DETAILED DESCRIPTION OF VARIOUS EMBODIMENTS

The details of one or more embodiments of the subject matter described herein are set forth in the accompanying drawings and the description below. Other features, aspects, and advantages of the subject matter will become apparent from the description, the drawings, and the claims.

Various embodiments of the present disclosure now will be described more fully hereinafter with reference to the accompanying drawings, in which some, but not all embodiments are shown. Indeed, the disclosure may be embodied in many forms and should not be construed as limited to the embodiments set forth herein; rather, these embodiments are provided so that this disclosure will satisfy applicable legal requirements. The term "or" is used herein in both the alternative and conjunctive sense, unless otherwise indicated. The terms "illustrative" and "example" are used to be examples with no indication of quality level. Like numbers refer to like elements throughout. Arrows in each of the figures depict bi-directional data flow and/or bi-directional data flow capabilities. The terms "path," "pathway" and "route" are used interchangeably herein.

Embodiments of the present disclosure may be implemented in various ways, including as computer program products that comprise articles of manufacture. A computer program product may include a non-transitory computer-readable storage medium storing applications, programs, program components, scripts, source code, program code, object code, byte code, compiled code, interpreted code, machine code, executable instructions, and/or the like (also referred to herein as executable instructions, instructions for execution, computer program products, program code, and/or similar terms used herein interchangeably). Such non-transitory computer-readable storage media includes all computer-readable media (including volatile and non-volatile media).

In one embodiment, a non-volatile computer-readable storage medium may include a floppy disk, flexible disk, hard disk, solid-state storage (SSS) (for example a solid-state drive (SSD)), solid state card (SSC), solid state module (SSM), enterprise flash drive, magnetic tape, or any other non-transitory magnetic medium, and/or the like. A non-volatile computer-readable storage medium may include a punch card, paper tape, optical mark sheet (or any other physical medium with patterns of holes or other optically recognizable indicia), compact disc read only memory (CD-ROM), compact disc-rewritable (CD-RW), digital versatile disc (DVD), Blu-ray disc (BD), any other non-transitory optical medium, and/or the like. Such a non-volatile computer-readable storage medium may include read-only memory (ROM), programmable read-only memory (PROM), erasable programmable read-only memory (EPROM), electrically erasable programmable read-only memory (EEPROM), flash memory (for example Serial, NAND, NOR, and/or the like), multimedia memory cards (MMC), secure digital (SD) memory cards, SmartMedia cards, CompactFlash (CF) cards, Memory Sticks, and/or the like. Further, a non-volatile computer-readable storage medium may include conductive-bridging random-access memory (CBRAM), phase-change random-access memory (PRAM), ferroelectric random-access memory (FeRAM), non-volatile random-access memory (NVRAM), magnetoresistive random-access memory (MRAM), resistive random-access memory (RRAM), Silicon-Oxide-Nitride-Oxide-Silicon memory (SONOS), floating junction gate random-access memory (FJG RAM), Millipede memory, racetrack memory, and/or the like.

In one embodiment, a volatile computer-readable storage medium may include random-access memory (RAM), dynamic random-access memory (DRAM), static random-access memory (SRAM), fast page mode dynamic random-access memory (FPM DRAM), extended data-out dynamic random-access memory (EDO DRAM), synchronous dynamic random-access memory (SDRAM), double data rate synchronous dynamic random-access memory (DDR SDRAM), double data rate type two synchronous dynamic random-access memory (DDR2 SDRAM), double data rate type three synchronous dynamic random-access memory (DDR3 SDRAM), Rambus dynamic random-access memory (RDRAM), Twin Transistor RAM (TTRAM), Thyristor RAM (T-RAM), Zero-capacitor (Z-RAM), Rambus in-line memory component (RIMM), dual in-line memory component (DIMM), single in-line memory component (SIMM), video random-access memory (VRAM), cache memory (including various levels), flash memory, register memory, and/or the like. It will be appreciated that where embodiments are described to use a computer-readable storage medium, other types of computer-readable storage media may be substituted for or used in addition to the computer-readable storage media described above.

As should be appreciated, various embodiments of the present disclosure may be implemented as methods, apparatus, systems, computing devices, computing entities, and/or the like. As such, embodiments of the present disclosure may take the form of an apparatus, system, computing device, computing entity, and/or the like executing instructions stored on a computer-readable storage medium to perform certain steps or operations. Thus, embodiments of the present disclosure may take the form of a hardware embodiment, a computer program product embodiment, and/or an embodiment that comprises a combination of computer program products and hardware performing certain steps or operations.

Embodiments of the present disclosure are described below with reference to block diagrams and flowchart illustrations. Thus, it should be understood that each block of the block diagrams and flowchart illustrations may be implemented in the form of a computer program product, a hardware embodiment, a combination of hardware and computer program products, and/or apparatus, systems, computing devices, computing entities, and/or the like carrying out instructions, operations, steps, and similar words used interchangeably (for example the executable instructions, instructions for execution, program code, and/or the like) on a computer-readable storage medium for execution. For example, retrieval, loading, and execution of code may be performed sequentially, such that one instruction is retrieved, loaded, and executed at a time. In some examples, retrieval, loading, and/or execution may be performed in parallel, such that multiple instructions are retrieved, loaded, and/or executed together. Thus, such embodiments can produce specifically configured machines performing the steps or operations specified in the block diagrams and flowchart illustrations. Accordingly, the block diagrams and flowchart illustrations support various combinations of embodiments for performing the specified instructions, operations, or steps.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not be necessarily all referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms, and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms, and a plural term may include the corresponding singular form. It is further noted that various figures (including component diagrams) shown and discussed herein are for illustrative purpose only, and are not drawn to scale. Similarly, various waveforms and timing diagrams are shown for illustrative purpose only. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some embodiments and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly referenced parts/modules are the only way to implement some of the embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on chip (SoC), an assembly, and so forth.

The provided description is presented to enable one of ordinary skill in the art to make and use the subject matter disclosed herein and to incorporate it in the context of particular applications. While the following is directed to specific examples, other and further examples may be devised without departing from the basic scope thereof.

Various modifications, as well as a variety of uses in different applications, will be readily apparent to those skilled in the art, and the general principles defined herein may be applied to a wide range of embodiments. Thus, the subject matter disclosed herein is not intended to be limited to the embodiments presented, but is to be accorded the widest scope consistent with the principles and novel features disclosed herein.

In the description provided, numerous specific details are set forth in order to provide a more thorough understanding of the subject matter disclosed herein. It will, however, be apparent to one skilled in the art that the subject matter disclosed herein may be practiced without necessarily being limited to these specific details. In other instances, well-known structures and devices are shown in block diagram form, rather than in detail, in order to avoid obscuring the subject matter disclosed herein.

All the features disclosed in this specification (e.g., any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Various features are described herein with reference to the figures. It should be noted that the figures are only intended to facilitate the description of the features. The various features described are not intended as an exhaustive description of the subject matter disclosed herein or as a limitation on the scope of the subject matter disclosed herein. Additionally, an illustrated example need not have all the aspects or advantages shown. An aspect or an advantage described in conjunction with a particular example is not necessarily limited to that example and can be practiced in any other examples even if not so illustrated, or if not so explicitly described.

It is noted that, if used, the labels left, right, front, back, top, bottom, forward, reverse, clockwise and counterclockwise have been used for convenience purposes only and are not intended to imply any particular fixed direction. Instead, the labels are used to reflect relative locations and/or directions between various portions of an object.

Data processing may include data buffering, aligning incoming data from multiple communication lanes, forward error correction (FEC), etc. For example, data may be received by an analog front end (AFE), which can prepare the incoming data for digital processing. The digital portion of the transceivers (e.g., digital signal processor (DSP)) may provide skew management, equalization, reflection cancellation, and/or other functions. It is to be appreciated that the process described herein can provide many benefits, including saving both power and cost.

Moreover, the terms "system," "component," "module," "interface," "model," or the like are generally intended to refer to a computer-related entity, either hardware, a combination of hardware and software, software, or software in execution. For example, a component may be, but is not limited to being, a process running on a processor, a processor, an object, an executable, a thread of execution, a program, and/or a computer. By way of illustration, both an application running on a controller and the controller can be a component. One or more components may reside within a process and/or thread of execution and a component may be localized on one computer and/or distributed between two or more computers.

Unless explicitly stated otherwise, each numerical value and range may be interpreted as being approximate, as if the word "about" or "approximately" preceded the value of the value or range. Signals and corresponding nodes or ports might be referred to by the same name and are interchangeable for purposes here.

While embodiments may have been described with respect to circuit functions, the embodiments of the subject matter disclosed herein are not limited. Possible implementations may be embodied in a single integrated circuit, a multi-chip module, a single card, SoC, or a multi-card circuit pack. As would be apparent to one skilled in the art, the various embodiments might also be implemented as part of a larger system. Such embodiments may be employed in conjunction with, for example, a digital signal processor, microcontroller, field-programmable gate array, application-specific integrated circuit, or general-purpose computer.

As would be apparent to one skilled in the art, various functions of circuit elements may also be implemented as processing blocks in a software program. Such software may be employed in, for example, a digital signal processor, microcontroller, or general-purpose computer. Such software may be embodied in the form of program code embodied in tangible media, such as magnetic recording media, optical recording media, solid-state memory, floppy diskettes, CD-ROMs, hard drives, or any other non-transitory machine-readable storage medium, that when the program code is loaded into and executed by a machine, such as a computer, the machine becomes an apparatus for practicing the subject matter disclosed herein. When implemented on a general-purpose processor, the program code segments combine with the processor to provide a unique device that operates analogously to specific logic circuits. Described embodiments may also be manifest in the form of a bit stream or other sequence of signal values electrically or optically transmitted through a medium, stored magnetic-field variations in a magnetic recording medium, etc., generated using a method and/or an apparatus as described herein.

Stacked memory can include three-dimensional dynamic random-access memory (3D-DRAM), vertically stacked DRAM (VS-DRAM), and the like. Stacked memory addresses the increasing demand for high-density, high-performance memory in modern computing systems. By stacking memory cells vertically, 3D-DRAM offers the potential for greater storage capacity and improved energy efficiency compared to traditional planar DRAM architectures.

However, as 3D-DRAM structures become more complex and densely packed, challenges arise in maintaining signal integrity and reducing noise during read and write operations. The placement and arrangement of bitlines, word lines, and other components can significantly impact the overall performance and reliability of the memory device.

One area of focus in 3D-DRAM design has been the configuration of bitlines. Open bitline structures have been used in some 3D-DRAM designs due to the placement constraints of local bitlines. In this arrangement, each bitline typically uses a neighboring die to define the reference signal during device operation. While functional, this approach can introduce challenges related to noise coupling and sensing margin.

As the density of 3D-DRAM continues to increase, there is ongoing interest in exploring alternative bitline architectures that may offer advantages in terms of signal quality, noise reduction, and overall device performance. Additionally, considerations such as process margins and integration with other components like core and peripheral transistors play a role in the evolution of 3D-DRAM designs.

Efforts to enhance 3D-DRAM technology often involve balancing multiple factors, including cell density, power consumption, reliability, and manufacturability. As such, innovations in memory cell structure, interconnect design, and fabrication techniques continue to be areas of active research and development in the field of 3D-DRAM.

According to aspects of the present disclosure, a three-dimensional dynamic random-access memory (3D-DRAM) device with a folded bitline is provided that improves the sensing margin of associated sense amplifiers. For example, the device may include a staggered channel structure (e.g., staggered trench isolation structure, staggered semiconductor channel structure, staggered silicon (Si) channel structure). In some cases, the device may include a folded bitline (BL) architecture enabled by the staggered channel structure. The folded bitline architecture may be implemented to improve sensing margin (e.g., compared to an open bitline structure).

In some examples, the staggered channel structure may be based on a staggered or offset trench isolation structure (e.g., staggered capacitive deep trench isolation (CDTI) structure). Based on the staggered channel structure, the device may include a local bitline (LBL) that is angled or tilted (e.g., relative to an orientation of the staggered channel structure) to enable the folded bitline architecture.

According to aspects of the present disclosure, a method of manufacturing a 3D-DRAM device is provided. The method may include forming a staggered channel structure (e.g., staggered CDTI, staggered semiconductor channel structure). The method may include implementing a folded bitline (BL) architecture enabled by the staggered channel structure. The folded bitline architecture can improve sensing margin (e.g., compared to an open bitline structure). The method may include tilting an LBL to enable the folded bitline architecture. For example, the method may include forming the LBL at an angle relative to the staggered channel structure and/or relative to a span of a global bitline.

The foregoing general description of the illustrative embodiments and the following detailed description thereof are merely exemplary aspects of the teachings of this disclosure and are not restrictive.

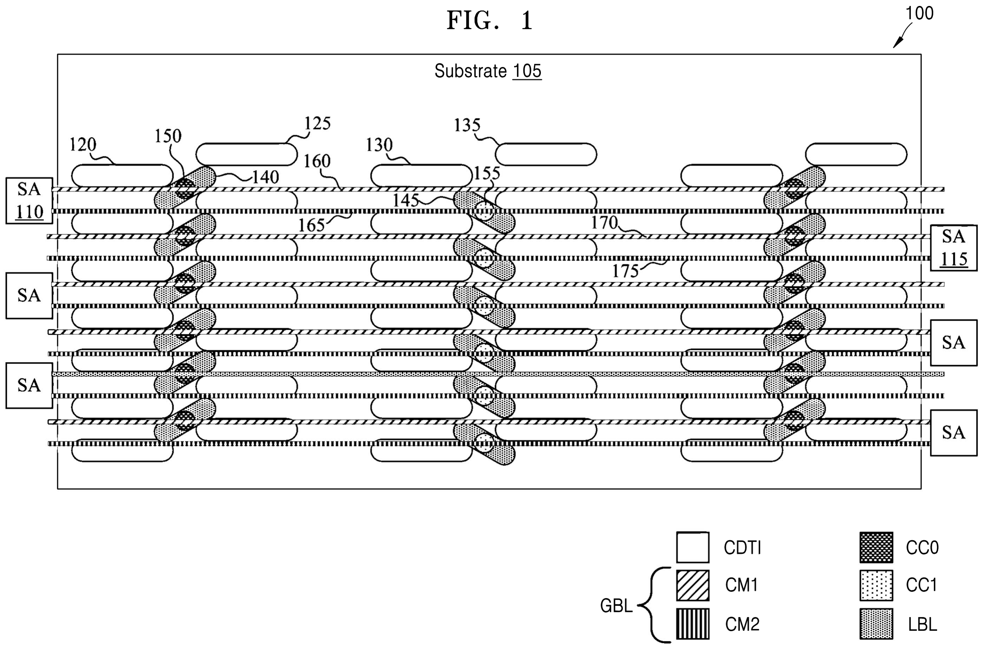

FIG. 1 illustrates an example architecture 100 in accordance with one or more implementations as described herein. Architecture 100 may depict a perspective or point of view of a stacked memory module. For example, architecture 100 may depict a top-down view of a stacked memory module. In some configurations, one or more aspects of architecture 100 may be implemented by or in conjunction with a fabrication device configured to form features and components of semiconductor fabrication (e.g., based on removal, etching, forming, depositing, etc.).

In the illustrated example, architecture 100 may include a substrate 105, multiple trench isolation structures (e.g., isolation trench 120, isolation trench 125, isolation trench 130, isolation trench 135), local bitlines (e.g., local bitline (LBL) 140, LBL 145), global bitlines (e.g., global bitline (GBL) 160, GBL 165, GBL 170, GBL 175), sense amplifiers (e.g., sense amplifier 110, sense amplifier 115), one or more first connectors (e.g., connector 150), and one or more second connectors (e.g., connector 155).

The substrate 105 may serve as a base for a 3D-DRAM structure of architecture 100. In some cases, the substrate 105 may be made of one or more semiconductor materials (e.g., silicon). The isolation trenches (e.g., isolation trench 120, isolation trench 125, isolation trench 130, isolation trench 135) may be formed in or on the substrate 105 to electrically isolate different components of the memory structure.

Local bitlines (e.g., LBL 140, LBL 145) may be formed to connect individual memory cells to the global bitlines. The global bitlines (e.g., GBL 160, GBL 165, GBL 170, GBL 175) may be used to transmit data signals between the memory cells and sense amplifiers of a 3D-DRAM structure.

The sense amplifiers (e.g., sense amplifier 110, sense amplifier 115) may be used to detect and amplify relatively small voltage differences on the bitlines during read operations. As shown, the sense amplifiers may be positioned at the ends of the global bitlines.

Connectors (e.g., connector 150, connector 155) may be used to establish electrical connections between different layers or components of the 3D-DRAM structure. For example, the connectors may connect local bitlines to global bitlines, establishing a connection between memory cells connected to the local bitlines and sense amplifiers.

In the illustrated example, the trench isolation structures (e.g., isolation trench 120, isolation trench 125, isolation trench 130, isolation trench 135) may be staggered. For ease of explanation, a set of isolation trenches depicted vertically in FIG. 1 may be referred to as a "column" of isolation trenches, as one isolation trench is formed above the other from the top-down perspective of FIG. 1. For example, isolation trench 120 may form a top of a first column of isolation trenches, isolation trench 125 may form a top of a second column of isolation trenches, isolation trench 130 may form a top of a third column of isolation trenches, and isolation trench 135 may form a top of a fourth column of isolation trenches. As shown, the first column of isolation trenches may be formed at an offset to the second column of isolation trenches (e.g., isolation trench 120 formed at an offset relative to isolation trench 125; isolation trench 125 shifted up relative to isolation trench 120). Similarly, the third column of isolation trenches may be formed at an offset to the fourth column of isolation trenches (e.g., isolation trench 130 formed at an offset relative to isolation trench 135; isolation trench 135 shifted up relative to isolation trench 130). Based on the offset, at least a portion of isolation trench 120 (e.g., width-wise) may align with a gap between isolation trench 125 and the next isolation trench below isolation trench 125. Similarly, based on the offset, at least a portion of isolation trench 130 (e.g., width-wise) may align with a gap between isolation trench 135 and the next isolation trench below isolation trench 135.

As shown, a given isolation trench may be formed with a width and a length, where the width is less than the length. Similarly, a given local bitline may be formed with a width and a length, where the width is less than the length. In relation to the top-down perspective of FIG. 1, the global bitlines run in the x-direction. Also, as depicted, the formation of the columns of isolation trenches are in the y-direction. Similarly, based on the depiction of FIG. 1, the formation of the local bitlines appear in "columns" in the y-direction (e.g., LBL 140 at the top of a first column of depicted bitlines, LBL 145 at the top of a second column of depicted bitlines, etc.).

The methods described herein may include tilting an LBL. For example, the method may include forming an LBL at an angle relative to the staggered channel structure and/or relative to a span of a global bitline.

In the illustrated example, at least a portion of the left end of LBL 140 may be formed within a gap between isolation trench 120 and the next isolation trench below isolation trench 120. Similarly, at least a portion of the right end of LBL 140 may be formed within a gap between isolation trench 125 and the next isolation trench below isolation trench 125. As shown, the depicted LBLs of architecture 100 may be tilted when formed. For example, LBLs of the depicted first column (e.g., LBL 140) may be formed at an angle relative to a given GBL or isolation trench (e.g., according to the depicted perspective). As shown, a lengthwise orientation of isolation trench 120 may be formed at or near a zero-angle relative to the x-direction of the depicted GBLs, while LBLs of the depicted first column (e.g., LBL 140) may be formed at an angle that ranges from 10 to 80 degrees.

In the illustrated example, at least a portion of the left end of LBL 145 may be formed within a gap between isolation trench 130 and the next isolation trench below isolation trench 130. Similarly, at least a portion of the right end of LBL 145 may be formed within a gap between isolation trench 135 and the next isolation trench below isolation trench 135. As shown, the depicted LBLs of architecture 100 may be tilted when formed. For example, LBLs of the depicted second column (e.g., LBL 145) may be formed at an angle relative to a given GBL or isolation trench. As shown, a lengthwise orientation of isolation trench 130 may be formed at or near a zero-angle relative to the x-direction of the depicted GBLs, while LBLs of the depicted second column (e.g., LBL 145) may be formed at an angle that ranges from 100 to 170 degrees (e.g., negative 10 degrees to negative 80 degrees).

In the depicted example, the LBLs (e.g., LBL 140, LBL 145) may extend in a z-direction (e.g., into the page from the depicted perspective of FIG. 1) in relation to the x-direction of the GBLs (e.g., GBL160, GBL 165, GBL170, GBL 175). The depicted connectors (e.g., connector 150, connector 155) may be positioned on top of the depicted LBLs, and the GBLs may run transversely above the connectors.

The depicted staggered trench isolation structure configuration may allow for a folded bitline structure, which may improve sensing margin and noise immunity compared to open bitline structures. This arrangement may enable more efficient use of space and may potentially improve overall memory performance.

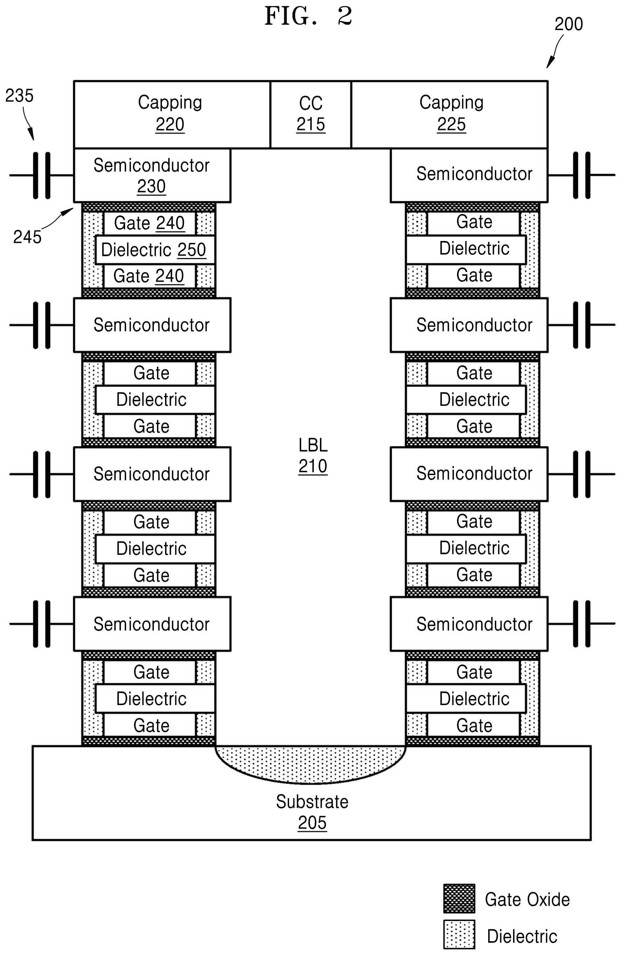

FIG. 2 illustrates details of architecture 200 in accordance with one or more implementations as described herein. Architecture 200 may depict a perspective or point of view of a stacked memory module. For example, architecture 200 may depict a cross-section view or side view of a stacked memory module. In particular, architecture 200 may depict a cross-section view of a folded bitline based on staggered trench isolation (e.g., staggered capacitive deep trench isolation (CDTI)). For example, architecture 200 may depict a cross-section view of architecture 100 of FIG. 1. In some configurations, one or more aspects of architecture 200 may be implemented by or in conjunction with a fabrication device configured to form features and components of semiconductor fabrication (e.g., based on removal, etching, forming, depositing, etc.).

In the illustrated example, architecture 200 may include substrate 205, LBL 210, at least one connector (e.g., connector 150, connector155), capping material (e.g., capping 220, capping 225, dielectric capping, semiconductor capping, metal capping, etc.), and semiconductor 230. As shown, architecture 200 may include one or more capacitors (e.g., capacitor 235).

In the illustrated example, a transistor may include a semiconductor (e.g., semiconductor 230), a gate (e.g., gate 240), a gate oxide (e.g., gate oxide 245), and a dielectric (e.g., dielectric 250). Semiconductor 230 and capacitor 235 may form a memory cell of architecture 200. As shown, a given semiconductor may be formed adjacent to a gate (e.g., gate metal) with a gate oxide separating the semiconductor and the gate. For example, semiconductor 230 may be formed adjacent to gate 240 (e.g., gate metal) with gate oxide 245 separating semiconductor 230 from gate 240. As shown, gate 240 may be formed adjacent to a dielectric (e.g., dielectric 250). In some cases, gate 240 may wrap around dielectric 250. As shown, the depicted capacitors (e.g., capacitor 235) may connect to respective transistors (e.g., semiconductor 230 connected to capacitor 235).

As shown, architecture 200 may include a first stack of semiconductors formed on top of substrate 205 and under capping 220 (e.g., semiconductor 230, capacitor 235) and a second stack of semiconductors formed on top of substrate 205 and under capping 225. As shown, LBL 210 may connect a first set of memory cells (e.g., under capping 225, including semiconductor 230, capacitor 235) to contact 215. Similarly, LBL 210 may connect a second set of memory cells (e.g., under capping 225) to contact 215. Contact 215 may connect LBL 210 to a global bitline. The global bitline may connect to a sense amplifier.

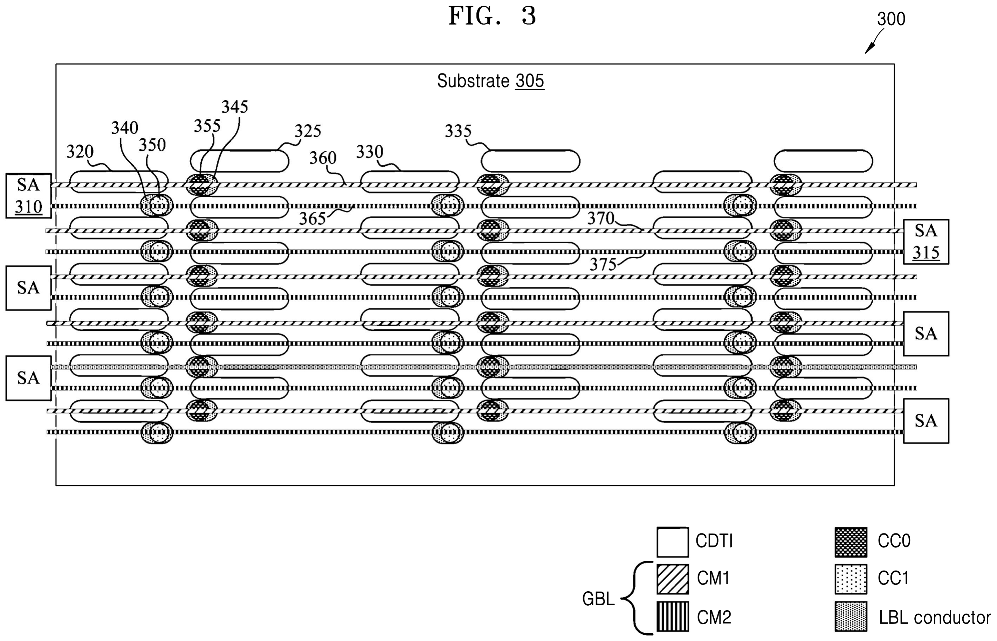

FIG. 3 illustrates an example architecture 300 in accordance with one or more implementations as described herein. Architecture 300 may depict a perspective or point of view of a stacked memory module. For example, architecture 300 may depict a top-down view of a stacked memory module. In some configurations, one or more aspects of architecture 300 may be implemented by or in conjunction with a fabrication device configured to form features and components of semiconductor fabrication (e.g., based on removal, etching, forming, depositing, etc.).

Architecture 300 may include a substrate 305, multiple sense amplifiers (e.g., SA 310, SA 315), and multiple isolation trenches (e.g., isolation trench 320, isolation trench 325, isolation trench 330, isolation trench 335).

Architecture 300 may also comprise one or more local bitline (LBL) conductors. For example, architecture 300 may include LBL conductor 340 and LBL conductor 345. These LBL conductors may be formed of conductive materials such as polysilicon, metal, or semiconductor materials.

In some cases, architecture 300 may include multiple connectors. For instance, architecture 300 may include connector 350 and connector 355. These connectors may serve to establish electrical connections between different components or layers within the memory structure. As shown, connector 350 may connect to LBL conductor 340 (e.g., at a top portion of LBL conductor 340 from the depicted top-down view) and connector 355 may connect to LBL conductor 345 (e.g., at a top portion of LBL conductor 345 from the depicted top-down view).

Architecture 300 may further include multiple global bitlines (GBLs). As shown, architecture 300 may include GBL 360, GBL 365, GBL 370, and GBL 375. In the illustrated example, GBL 360 and GBL 365 may connect to SA 310, while GBL 370 and GBL 375 may connect to SA 315. These global bitlines may be used to transmit data signals between memory cells and sense amplifiers. In the depicted top-down view, the depicted LBL conductors may extend down into the page. Also, the memory cells may extend down into the page adjacent to and connected to the LBL conductors.

The arrangement of components in architecture 300 may contribute to the folded bitline structure. For example, GBL 360 and GBL 365 may be connected to SA 310, while GBL 370 and GBL 375 may be connected to SA 315. This configuration may allow for improved noise immunity and sensing margin compared to open bitline structures. Also, this configuration may allow for more effective noise cancellation during read operations. For example, GBL 365 may be used as a voltage reference when SA 310 reads a signal on GBL 360, and vice versa. Similarly, GBL 375 may be used as a voltage reference when SA 315 reads a signal on GBL 370, and vice versa

In some cases, the local bitlines in architecture 300 may be tilted. For instance, connector 350 may be connected to a tilted local bitline. This tilted configuration of the local bitlines may contribute to the folded bitline structure and may allow for more efficient use of space within the memory architecture. In some cases, an angle between the first local bitline 340 and the second local bitline 345 ranges from 10 degrees to 80 degrees relative to an orientation of the first set of isolation trenches 320 and the second set of isolation trenches 325 that are oriented at a zero angle. That angle may be an angle between a line connecting the centers of the first and second local bitlines in the plane of FIG. 3 and an orientation of the isolation trenches 320, 325.

In the illustrated example, the LBL conductors may be formed within gaps between the isolation trenches. For example, LBL conductor 340 (e.g., and connector 350) may be formed within the gap between isolation trench 320 and the next isolation trench below isolation trench 320. Similarly, LBL conductor 345 (e.g., and connector 355) may be formed within the gap between isolation trench 325 and the next isolation trench below isolation trench 325. As shown, an LBL conductor and connector may be formed within the gap between isolation trench 330 and the next isolation trench below isolation trench 330. Similarly, an LBL conductor and connector may be formed within the gap between isolation trench 335 and the next isolation trench below isolation trench 335.

In some implementations, based on the offset isolation trenches, at least a portion of a GBL may at least partially align or pass over some isolation trenches and at least partially pass between isolation trenches (e.g., at least partially align or pass over gaps between isolation trenches). For example, GBL 360 may at least align with the gap between isolation trench 325 and the next isolation trench below isolation trench 325, and at least partially align with the gap between isolation trench 335 and the next isolation trench below isolation trench 335. Also, GBL 360 may at least partially align or pass over isolation trench 320 and isolation trench 330. Similarly, GBL 365 may at least align with the gap between isolation trench 320 and the next isolation trench below isolation trench 320, and at least partially align with the gap between isolation trench 330 and the next isolation trench below isolation trench 330. Also, GBL 365 may at least partially align or pass over the next isolation trench below isolation trench 325 and the next isolation trench below isolation trench 335.

The staggered arrangement of isolation trenches (e.g., isolation trench 325, isolation trench 330, isolation trench 335) may facilitate the formation of the folded bitline structure. This staggered configuration may enable the positioning of memory cells and bitlines in a manner that supports the folded bitline architecture.

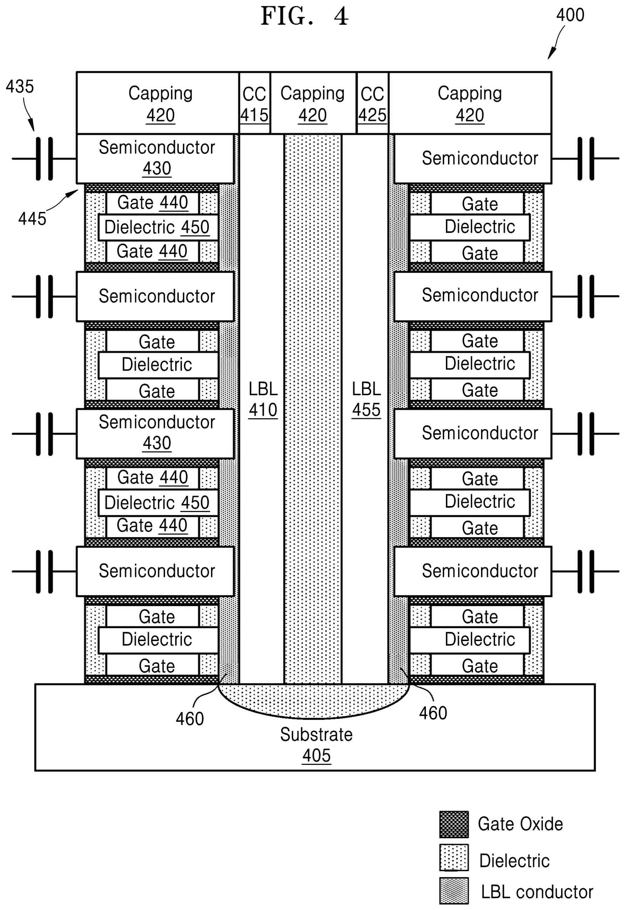

**FIG. 4** illustrates an example architecture 400 in accordance with one or more implementations as described herein. Architecture 400 may depict a perspective or point of view of a stacked memory module. For example, architecture 400 may depict a cross-section view or side view of a stacked memory module. In particular, architecture 400 may depict a cross-section view of a folded bitline based on staggered trench isolation (e.g., staggered capacitive deep trench isolation (CDTI)). For example, architecture 400 may depict a cross-section view of architecture 300 of FIG. 3. In some configurations, one or more aspects of architecture 400 may be implemented by or in conjunction with a fabrication device configured to form features and components of semiconductor fabrication (e.g., based on removal, etching, forming, depositing, etc.).

In the illustrated example, architecture 400 may include a substrate 405, a local bitline (LBL) 410, a connector 415 (e.g., a first connector), and capping 420 (e.g., capping material, dielectric capping, semiconductor capping, metal capping, etc.). Architecture 400 may also include connector 425 (e.g., a second connector) and LBL 455. As shown, connector 415 may be connected to LBL 410. Connector 425 may be connected to LBL 455.

Architecture 400 may include multiple stacks of memory cells formed on top of substrate 405. In some cases, a first stack of memory cells may be formed on the left side of architecture 400, while a second stack of memory cells may be formed on the right side. Each stack may include one or more memory cells.

A memory cell in architecture 400 may include a semiconductor 430 connected to a capacitor 435. For example, semiconductor 430 may be electrically coupled to capacitor 435 to form a single memory cell within the first stack.

In some cases, semiconductor 430 may be formed adjacent to a gate 440. A gate oxide 445 may separate semiconductor 430 from gate 440. Gate 440 may be positioned adjacent to a dielectric 450. In some implementations, gate 440 may wrap around dielectric 450.

The LBL of architecture 400 may include LBL 410, LBL 455, and a LBL conductor 460. LBL conductor 460 may be formed of conductive materials such as metal, semiconductor, polysilicon, etc. In some cases, LBL 410 may connect a first stack of memory cells (e.g., stack to the left, including semiconductor 430 and capacitor 435) to connector 415. Similarly, LBL 455 may connect a second stack of memory cells (e.g., stack to the right) to connector 425. As shown, a first portion of LBL conductor 460 may connect the first stack of memory cells to LBL 410. Similarly, a second portion of LBL conductor 460 may connect the second stack of memory cells to LBL 455.

Architecture 400 may be based on a staggered arrangement of the capacitive deep trench isolation (CDTI), which may facilitate the formation of the folded bitline structure. This staggered configuration may enable the positioning of memory cells and bitlines in a manner that supports the folded bitline architecture. The staggered CDTI may allow for improved sensing margin and noise immunity compared to open bitline structures. The improved sensing margin may result from the arrangement of the local bitlines and global bitlines in the folded configuration. This configuration may allow for more efficient routing of signals within the memory array and potentially improve overall memory performance.

The staggered arrangement of isolation trenches may enable more efficient use of space within the memory architecture and may improve overall memory performance. The staggered arrangement of isolation trenches may allow for more efficient use of space within the memory architecture, potentially leading to higher density memory designs. In some cases, the staggered arrangement of isolation trenches may enable relaxed process margins in the sense amplifier pitch. This relaxation of process margins may provide greater flexibility in manufacturing and may potentially improve yield rates. In some cases, the relaxed process margins in the sense amplifier pitch may enable better integration with core and peripheral transistors. For example, the additional margin in the sense amplifier pitch may allow for more efficient bonding processes when integrating the memory array with other components of a system-on-chip design.

In some cases, the combination of the staggered arrangement of isolation trenches and folded bitline architecture may result in a memory design that balances performance, density, and manufacturability. These design features may work together to address challenges in 3D-DRAM design, potentially leading to improved memory solutions for various applications.

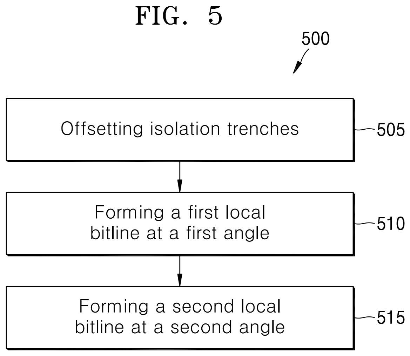

**FIG. 5** depicts a flow diagram illustrating an example method 500 associated with the disclosed systems, in accordance with example implementations described herein. In some configurations, one or more aspects of method 500 may be implemented by or in conjunction with a fabrication device configured to form features and components of semiconductor fabrication (e.g., based on removal, etching, forming, depositing, etc.). The depicted method 500 is just one implementation, and one or more operations of method 500 may be rearranged, reordered, omitted, and/or otherwise modified such that other implementations are possible and contemplated.

At 505, method 500 may include offsetting isolation trenches. For example, a fabrication device may offset a position of a first set of isolation trenches relative to a position of a second set of isolation trenches based on a given perspective (e.g., top-down view) of a stacked memory system. In some cases, the fabrication device may offset a position of a third set of isolation trenches relative to a position of a fourth set of isolation trenches from the perspective of the stacked memory system.

At 510, method 500 may include forming a first local bitline at a first angle. For example, the fabrication device may form a first local bitline at a first angle relative to the first set of isolation trenches and the second set of isolation trenches.

At 515, method 500 may include forming a second local bitline at a second angle. For example, the fabrication device may form a second local bitline at a second angle relative to the third set of isolation trenches and the fourth set of isolation trenches, the second angle being different from the first angle.

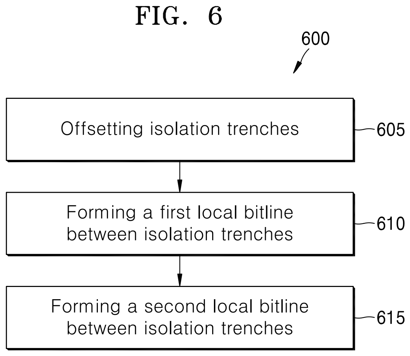

**FIG. 6** depicts a flow diagram illustrating an example method 600 associated with the disclosed systems, in accordance with example implementations described herein. In some configurations, one or more aspects of method 600 may be implemented by or in conjunction with a fabrication device configured to form features and components of semiconductor fabrication (e.g., based on removal, etching, forming, depositing, etc.). The depicted method 600 is just one implementation, and one or more operations of method 600 may be rearranged, reordered, omitted, and/or otherwise modified such that other implementations are possible and contemplated.

At 605, method 600 may include offsetting isolation trenches. For example, the fabrication device may offset a position of a first set of isolation trenches relative to a position of a second set of isolation trenches based on a given perspective (e.g., top-down view) of the stacked memory system.

At 610, method 600 may include forming a first local bitline between isolation trenches. For example, the fabrication device may form a first local bitline between a first isolation trench and a second isolation trench of the first set of isolation trenches.

At 615, method 600 may include forming a second local bitline between isolation trenches. For example, the fabrication device may form a second local bitline between a third isolation trench and a fourth isolation trench of the second set of isolation trenches.

In the examples described herein, the configurations and operations are example configurations and operations, and may involve various additional configurations and operations not explicitly illustrated. In some examples, one or more aspects of the illustrated configurations and/or operations may be omitted. In some embodiments, one or more of the operations may be performed by components other than those illustrated herein. Additionally, or alternatively, the sequential and/or temporal order of the operations may be varied.

Certain embodiments may be implemented in one or a combination of hardware, firmware, and software. Other embodiments may be implemented as instructions stored on a computer-readable storage device, which may be read and executed by at least one processor to perform the operations described herein. A computer-readable storage device may include any non-transitory memory mechanism for storing information in a form readable by a machine (e.g., a computer). For example, a computer-readable storage device may include read-only memory (ROM), random-access memory (RAM), magnetic disk storage media, optical storage media, flash-memory devices, and other storage devices and media.

The word "exemplary" is used herein to mean "serving as an example, instance, or illustration." Any embodiment described herein as "exemplary" is not necessarily to be construed as preferred or advantageous over other embodiments. The terms "computing device," "user device," "communication station," "station," "handheld device," "mobile device," "wireless device" and "user equipment" (UE) as used herein refers to a wired and/or wireless communication device such as a switch, router, network interface controller, cellular telephone, smartphone, tablet, netbook, wireless terminal, laptop computer, a femtocell, High Data Rate (HDR) subscriber station, access point, printer, point of sale device, access terminal, or other personal communication system (PCS) device. The device may be wireless, wired, mobile, and/or stationary.

As used within this document, the term "communicate" is intended to include transmitting, or receiving, or both transmitting and receiving. Similarly, the bidirectional exchange of data between two devices (both devices transmit and receive during the exchange) may be described as 'communicating', when only the functionality of one of those devices is being claimed. The term "communicating" as used herein with respect to wired and/or wireless communication signals includes transmitting the wired and/or wireless communication signals and/or receiving the wired and/or wireless communication signals. For example, a communication unit, which is capable of communicating wired and/or wireless communication signals, may include a wired/wireless transmitter to transmit communication signals to at least one other communication unit, and/or a wired/wireless communication receiver to receive the communication signal from at least one other communication unit.

Some embodiments may be used in conjunction with various devices and systems, for example, a Personal Computer (PC), a desktop computer, a mobile computer, a laptop computer, a notebook computer, a tablet computer, a server computer, a handheld computer, a handheld device, a Personal Digital Assistant (PDA) device, a handheld PDA device, an on-board device, an off-board device, a hybrid device, a vehicular device, a non-vehicular device, a mobile or portable device, a consumer device, a non-mobile or non-portable device, a wireless communication station, a wireless communication device, a wireless Access Point (AP), a wired or wireless router, a wired or wireless modem, a video device, an audio device, an audio-video (A/V) device, a wired or wireless network, a wireless area network, a Wireless Video Area Network (WVAN), a Local Area Network (LAN), a Wireless LAN (WLAN), a Personal Area Network (PAN), a Wireless PAN (WPAN), and the like.

Some embodiments may be used in conjunction with one way and/or two-way radio communication systems, cellular radio-telephone communication systems, a mobile phone, a cellular telephone, a wireless telephone, a Personal Communication Systems (PCS) device, a PDA device which incorporates a wireless communication device, a mobile or portable Global Positioning System (GPS) device, a device which incorporates a GPS receiver or transceiver or chip, a device which incorporates an RFID element or chip, a Multiple Input Multiple Output (MIMO) transceiver or device, a Single Input Multiple Output (SIMO) transceiver or device, a Multiple Input Single Output (MISO) transceiver or device, a device having one or more internal antennas and/or external antennas, Digital Video Broadcast (DVB) devices or systems, multi-standard radio devices or systems, a wired or wireless handheld device, e.g., a Smartphone, a Wireless Application Protocol (WAP) device, or the like.

Some embodiments may be used in conjunction with one or more types of wireless communication signals and/or systems following one or more wireless communication protocols, for example, Radio Frequency (RF), Infrared (IR), Frequency-Division Multiplexing (FDM), Orthogonal FDM

(OFDM), Time-Division Multiplexing (TDM), Time-Division Multiple Access (TDMA), Extended TDMA (E-TDMA), General Packet Radio Service (GPRS), extended GPRS, Code-Division Multiple Access (CDMA), Wideband CDMA (WCDMA), CDMA 2000, single-carrier CDMA, multi-carrier CDMA, Multi-Carrier Modulation (MDM), Discrete Multi-Tone (DMT), Bluetooth^{™}, Global Positioning System (GPS), Wi-Fi, Wi-Max, ZigBee^{™}, Ultra-Wideband (UWB), Global System for Mobile communication (GSM), 2G, 2.5G, 3G, 3.5G, 4G, Fifth Generation (5G) mobile networks, 3GPP, Long Term Evolution (LTE), LTE advanced, Enhanced Data rates for GSM Evolution (EDGE), or the like. Other embodiments may be used in various other devices, systems, and/or networks.

Although an example processing system has been described above, embodiments of the subject matter and the functional operations described herein can be implemented in other types of digital electronic circuitry, or in computer software, firmware, or hardware, including the structures disclosed in this specification and their structural equivalents, or in combinations of one or more of them.

Embodiments of the subject matter and the operations described herein can be implemented in digital electronic circuitry, or in computer software, firmware, or hardware, including the structures disclosed in this specification and their structural equivalents, or in combinations of one or more of them. Embodiments of the subject matter described herein can be implemented as one or more computer programs, i.e., one or more components of computer program instructions, encoded on computer storage medium for execution by, or to control the operation of, information/data processing apparatus. Alternatively, or in addition, the program instructions can be encoded on an artificially-generated propagated signal, for example, a machine-generated electrical, optical, or electromagnetic signal, which is generated to encode information/data for transmission to suitable receiver apparatus for execution by an information/data processing apparatus. A computer storage medium can be, or be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially-generated propagated signal. The computer storage medium can also be, or be included in, one or more separate physical components or media (for example multiple CDs, disks, or other storage devices).

The operations described herein can be implemented as operations performed by an information/data processing apparatus on information/data stored on one or more computer-readable storage devices or received from other sources.

The term "data processing apparatus" encompasses all kinds of apparatus, devices, and machines for processing data, including by way of example a programmable processor, a computer, a system on a chip, or multiple ones, or combinations, of the foregoing. The apparatus can include special purpose logic circuitry, for example, an FPGA or an ASIC. The apparatus can also include, in addition to hardware, code that creates an execution environment for the computer program in question, for example code that constitutes processor firmware, a protocol stack, a database management system, an operating system, a cross-platform runtime environment, a virtual machine, or a combination of one or more of them. The apparatus and execution environment can realize various different computing model infrastructures, such as web services, distributed computing and grid computing infrastructures.

A computer program (also known as a program, software, software application, script, or code) can be written in any form of programming language, including compiled or interpreted languages, declarative or procedural languages, and it can be deployed in any form, including as a stand-alone program or as a component, component, subroutine, object, or other unit suitable for use in a computing environment. A computer program may, but need not, correspond to a file in a file system. A program can be stored in a portion of a file that holds other programs or information/data (for example one or more scripts stored in a markup language document), in a single file dedicated to the program in question, or in multiple coordinated files (for example files that store one or more components, sub-programs, or portions of code). A computer program can be deployed to be executed on one computer or on multiple computers that are located at one site or distributed across multiple sites and interconnected by a communication network.

The processes and logic flows described herein can be performed by one or more programmable processors executing one or more computer programs to perform actions by operating on input information/data and generating output. Processors suitable for the execution of a computer program include, by way of example, both general and special purpose microprocessors, and any one or more processors of any kind of digital computer. Generally, a processor will receive instructions and information/data from a read-only memory or a random-access memory or both. The essential elements of a computer are a processor for performing actions in accordance with instructions and one or more memory devices for storing instructions and data. Generally, a computer will also include, or be operatively coupled to receive information/data from or transfer information/data to, or both, one or more mass storage devices for storing data, for example magnetic, magneto-optical disks, or optical disks. However, a computer need not have such devices. Devices suitable for storing computer program instructions and information/data include all forms of non-volatile memory, media and memory devices, including by way of example semiconductor memory devices, for example EPROM, EEPROM, and flash memory devices; magnetic disks, for example internal hard disks or removable disks; magneto-optical disks; and CD-ROM and DVD-ROM disks. The processor and the memory can be supplemented by, or incorporated in, special purpose logic circuitry.

To provide for interaction with a user, embodiments of the subject matter described herein can be implemented on a computer having a display device, for example, a CRT (cathode ray tube) or LCD (liquid crystal display) monitor, for displaying information/data to the user and a keyboard and a pointing device, for example, a mouse or a trackball, by which the user can provide input to the computer. Other kinds of devices can be used to provide for interaction with a user as well; for example, feedback provided to the user can be any form of sensory feedback, for example visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's client device in response to requests received from the web browser.

Embodiments of the subject matter described herein can be implemented in a computing system that includes a back-end component, for example, as an information/data server, or that includes a middleware component, for example, an application server, or that includes a front-end component, for example, a client computer having a graphical user interface or a web browser through which a user can interact with an embodiment of the subject matter described herein, or any combination of one or more such back-end, middleware, or front-end components. The components of the system can be interconnected by any form or medium of digital information/data communication, for example, a communication network. Examples of communication networks include a local area network ("LAN") and a wide area network ("WAN"), an inter-network (for example the Internet), and peer-to-peer networks (for example ad hoc peer-to-peer networks).

The computing system can include clients and servers. A client and server are generally remote from each other and typically interact through a communication network. The relationship of client and server arises by virtue of computer programs running on the respective computers and having a client-server relationship to each other. In some embodiments, a server transmits information/data (for example, an HTML page) to a client device (for example, for purposes of displaying information/data to and receiving user input from a user interacting with the client device). Information/data generated at the client device (for example, a result of the user interaction) can be received from the client device at the server.

While this specification contains many specific embodiment details, these should not be construed as limitations on the scope of any embodiment or of what may be claimed, but rather as descriptions of features specific to particular embodiments. Certain features that are described herein in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain embodiments, multitasking and parallel processing may be advantageous.

Many modifications and other examples as set forth herein will come to mind to one skilled in the art to which these embodiments pertain to having the benefit of the teachings presented in the foregoing descriptions and the associated drawings. Therefore, it is to be understood that the embodiments are not to be limited to the specific embodiments disclosed and that modifications and other embodiments are intended to be included within the scope of the appended claims. Although specific terms are employed herein, they are used in a generic and descriptive sense only and not for purposes of limitation. A number of example implementations have been described. Nevertheless, it will be understood that various modifications may be made without departing from the scope of the disclosure. Accordingly, additional implementations are within the scope of the following claims.

## Claims

1. A stacked memory device comprising:
a first set of isolation trenches (120) and a second set of isolation trenches (125), a position of the first set of isolation trenches (120) being offset relative to a position of the second set of isolation trenches (125);
a first local bitline (140) formed at a first angle relative to an orientation of the first set of isolation trenches (120) and the second set of isolation trenches (125);
a third set of isolation trenches (130) and a fourth set of isolation trenches (135), a position of the third set of isolation trenches (130) being offset relative to a position of the fourth set of isolation trenches (135); and
a second local bitline (145) formed at a second angle relative to an orientation of the third set of isolation trenches (130) and the fourth set of isolation trenches (135), the second angle being different from the first angle.

2. The stacked memory device of claim 1, wherein the first angle of the first local bitline (140) ranges from 10 degrees to 80 degrees relative to the orientation of the first set of isolation trenches (120) and the second set of isolation trenches (125) that are oriented at a zero angle.

3. The stacked memory device of claim 2, wherein:
a first connector (150) connects the first local bitline (140) to a first global bitline (160),
the first global bitline (160) connects the first local bitline (140) to a first sense amplifier (110), and
the first global bitline (160) is positioned at the zero angle.

4. The stacked memory device of any one of claims 1 to 3, wherein:
the second angle of the second local bitline (145) ranges from 100 degrees to 170 degrees relative to the orientation of the third set of isolation trenches (130) and the fourth set of isolation trenches (135) that are oriented at a zero angle.

5. The stacked memory device of claim 4, wherein:
a second connector (155) connects the second local bitline (145) to a second global bitline (165),
the second global bitline (165) connects the second local bitline (145) to a second sense amplifier (110), and
the second global bitline (165) is positioned at the zero angle.

6. The stacked memory device of any one of claims 1 to 5, wherein a first portion of the first local bitline (140) is formed between a first isolation trench and a second isolation trench of the first set of isolation trenches (120).

7. The stacked memory device of any one of claims 1 to 6, wherein a second portion of the first local bitline (140) is formed between a third isolation trench and a fourth isolation trench of the second set of isolation trenches (125).

8. The stacked memory device of any one of claims 1 to 7, wherein the first local bitline (140) connects to a first column of memory cells and a second column of memory cells.

9. A stacked memory device comprising:
a first set of isolation trenches (320) and a second set of isolation trenches (325), a position of the first set of isolation trenches (320) being offset relative to a position of the second set of isolation trenches (325);
a first local bitline (340) formed between a first isolation trench and a second isolation trench of the first set of isolation trenches (320); and
a second local bitline (345) formed between a third isolation trench and a fourth isolation trench of the second set of isolation trenches (325).

10. The stacked memory device of claim 9, wherein a position of the first local bitline (340) is offset relative to a position of the second local bitline (345).

11. The stacked memory device of claim 9 or 10, wherein an angle between the first local bitline (340) and the second local bitline (345) ranges from 10 degrees to 80 degrees relative to an orientation of the first set of isolation trenches (320) and the second set of isolation trenches (125; 325) that are oriented at a zero angle.

12. The stacked memory device of any one of claims 9 to 11, wherein:
a first connector (350) connects the first local bitline (340) to a first global bitline (365), and
the first global bitline (365) connects the first local bitline (340) to a first sense amplifier (310).

13. The stacked memory device of claim 12, wherein:
the first global bitline (365) is positioned at least partially between the first isolation trench and the second isolation trench, and
the first global bitline (365) is positioned at a zero angle.

14. The stacked memory device of any one of claims 9 to 13, wherein:
a second connector (355) connects the second local bitline (345) to a second global bitline (360),
the second global bitline (360) connects the second local bitline (345) to a second sense amplifier (310),
the second global bitline (360) is positioned at least partially between the third isolation trench and the fourth isolation trench, and
the second global bitline (360) is positioned at a zero angle.

15. The stacked memory device of any one of claims 9 to 14, wherein:
the first local bitline (340) connects to a first column of memory cells, and
the second local bitline (345) connects to a second column of memory cells.
